# EUROPEAN PATENT SPECIFICATION

(11) **EP 0 517 369 B1**
(45) Date of publication and mention of the grant of the patent: **02.04.1997**
(21) Application number: 92303982.0
(22) Date of filing: 01.05.1992
(51) Int. Cl.: H01L 21/60, H01L 25/16, H01S 3/025

(54) **Process of manufacturing opto-electronic hybrid modules**
Verfahren zur Herstellung von optoelektronischen, hybriden Modulen
Procédé de fabrication de modules opto-électroniques hybrides

(30) Priority: 10.05.1991 GB 9110155
(43) Date of publication of application: 09.12.1992
(73) Proprietor: NORTHERN TELECOM LIMITED, Montreal, Quebec H2Y 3Y4 (CA)
(72) Inventor: Parker, James Wilson, Bishop's Stortford, Herts (GB); Harrison, Paul Mark, Springfield, Chelmsford CM1 5XD (GB); Peall, Robert George, Harlow, Essex CM20 3LT (GB)
(74) Representative: Laurence, Simon French

(56) References cited:
- WO-A-90/07792
- FR-A- 2 247 820
- US-A- 4 875 617
- PATENT ABSTRACTS OF JAPAN vol. 9, no. 284 (E-357)12 November 1985 & JP-A-60 124 947
- PATENT ABSTRACTS OF JAPAN vol. 13, no. 240 (E-767)6 June 1989 & JP-A-01 144 049
- PATENT ABSTRACTS OF JAPAN vol. 13, no. 240 (E-767)27 April 1989 & Jp-A-01 007 638
- IEEE TRANSACTIONS ON COMPONENTS,HYBRIDS,AND MANUFACTURING TECHNOLOGY vol. 13, no. 3, September 1990, NEW YORK US pages 521 - 527 HATADA ET AL. 'LED ARRAY MODULES BY NEW TECHNOLOGY MICROBUMP BONDING METHOD'
- PATENT ABSTRACTS OF JAPAN vol. 12, no. 164 (M-698)18 May 1988 & JP-A-62 280 056
- PATENT ABSTRACTS OF JAPAN vol. 7, no. 18 (P-170)25 January 1983 & JP-A-57 172 308

## Description

This invention relates to opto-electronic components and in particular to processes for use in manufacturing high performance components in opto-electronic hybrid module form, especially silicon opto-hybrid form.

The advantages of optical interconnects in telecommunications systems have been thoroughly demonstrated. However, as the interconnect length reduces to tens of centimetres or less, such as in computer systems and referred to hereinafter, these advantages are harder to realise. One reason for this is that optical components have traditionally been packaged separately from electronic devices, which results in a relatively low density of integration. In order to increase interconnection capabilities, new ways of packaging optical, opto-electronic and electronic components will be required.

One approach is the monolithic integration of opto-electronic components, however the monolithic integration of arrays of laser with electronic multiplexer and logic circuits presents extreme technological difficulties which are unlikely to be overcome for some years.

Another possibility is to make use of hybrid multi-chip modules. Hybrid mounting techniques allow the independent optimisation of the individual optical and electronic components. For example, InP or GaAs lasers can be mixed with silicon integrated circuits and InGaAs or Si photodetectors. In this way complex and densely packed integrated opto-electronic subsystems can be manufactured which make the best use of each technology.

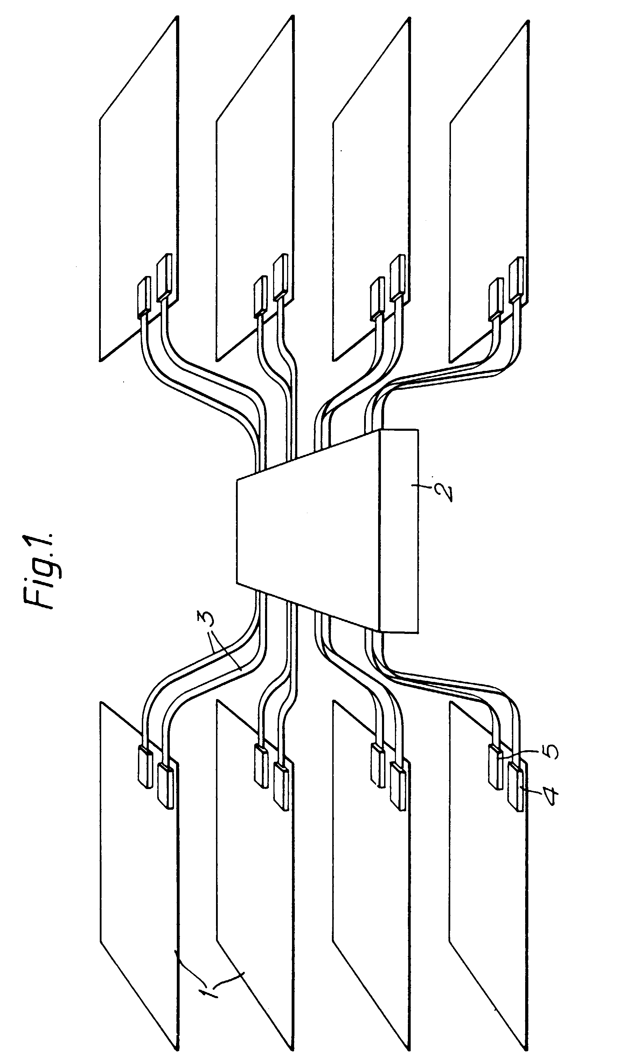

A particular application of opto-hybrid technology in multiprocessor mainframe computers is that of a wideband optical bus. This is an optical implementation of a time division multiplexed bus and is illustrated in Fig. 1. Each of a number of nodes (electronic circuit boards) 1, in this case eight nodes, are interconnected by central star coupler 2 and multi-element optical ribbon fibre cable 3. At each node there are array transmitter (4) and receiver (5) modules. The whole acts as a broadcast network; all the data transmitted at one node is received by all the others. The basic network shown could operate at up to 32Gbit/s and multiple instances would be combined in parallel to achieve the overall throughput required. It will be appreciated that this is only an example. There are many other applications in computers, telecommunications systems and elsewhere.

A number of components are required to build such a network; array transmitter and receiver modules, the passive optical star coupler and optical ribbon fibre cable. Attention is directed to our co-pending GB Application No 8925539.2 (Serial No 2237949) (J W Parker 5) which relates to various aspects of such a network, in particular the coupler and the transmitter and receiver modules and discusses realisations of the latter in silicon opto-hybrid form, which form can achieve the necessary compactness and reliability at a reasonable cost.

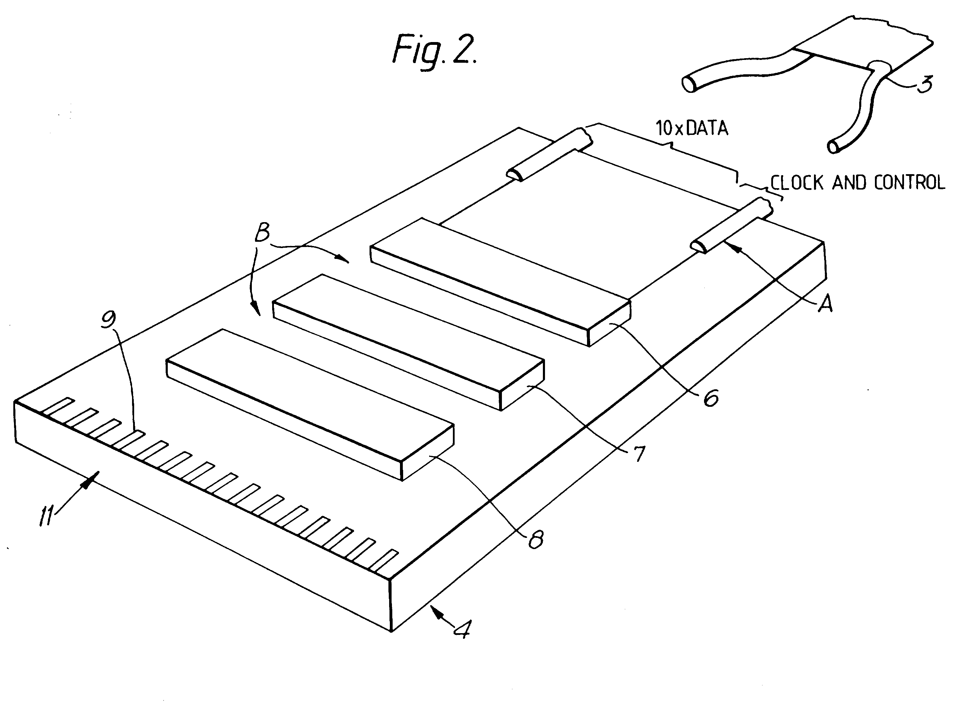

The layout of a transmitter module 4, is shown schematically in Fig. 2. Each module comprises a twelve element laser array 6, a twelve element laser driver array 7 and a twelve element MUX array 8 whereby several lower speed inputs can be combined into one data stream. Fifteen parallel low bit rate data inputs are indicated at 9 but in practice the number may be very much higher. Ten of the twelve outputs A (ten of fibres) are data outputs at say 3.2 Gbit/s, whereas one of the other outputs is used to transmit a common clock and the other is for control purposes, such as for transmitting parity information. Electrical interconnects are not shown in Fig. 2, but will for example be at B. The light from the rear facet of the laser array is monitored by an array of backface detectors (not shown in Fig. 2) whose output signals provide a bias to the respective laser driver to ensure that the lasers are kept at threshold. The output from the lasers is coupled into the ribbon fibre 3 either directly or by the use of ball lenses. The receiver module has a similar form of layout to the transmitter and can be fabricated by identical technology.

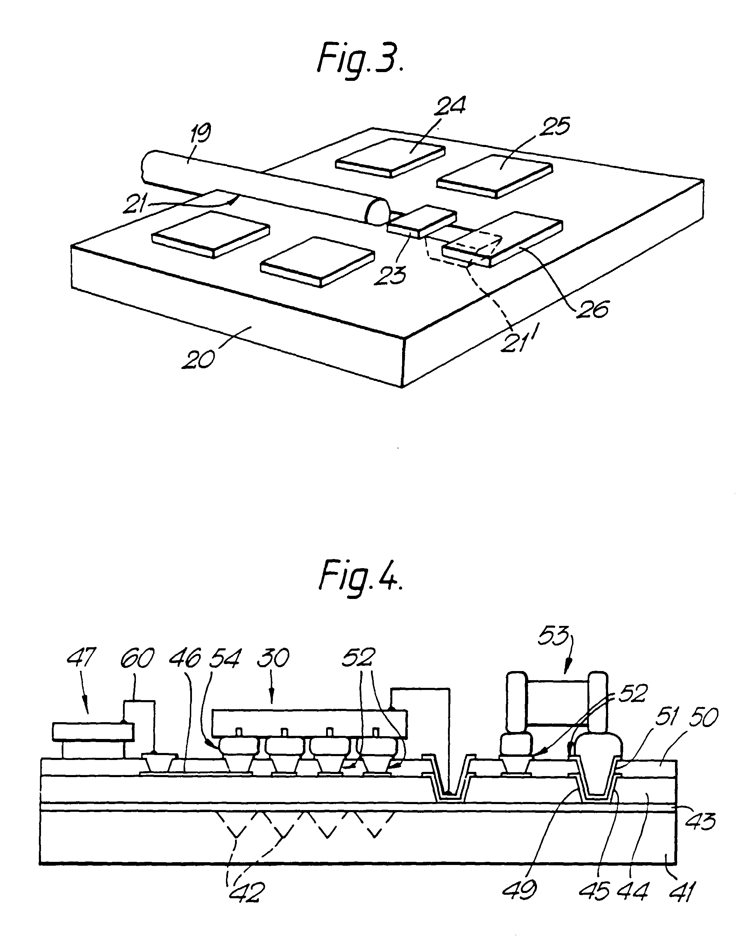

A basic transmitter module in silicon opto-hybrid form is described in GB Application No 8925539.2 (Serial No 2237949) and is shown in Fig. 3. For simplicity and clarity only one laser, one fibre and the associated driver and multiplex chips are shown. The electrical connections are omitted. The module involves a silicon substrate 20 in which a V-groove is provided. In the case of a (100) silicon substrate anisotropic etching using etching techniques mentioned hereinafter will produce V-shaped wells with the plane side walls formed by the (111) planes. With appropriate masking the groove can be made open at one end for reception of the fibre 19 and closed at the other end as indicated. Also etched in the substrate and aligned with groove 21 is a well 21' with an inclined end wall which provides a reflector, that can be metallised to improve reflectivity as can the well walls adjoining it, whose purpose will be apparent from the following. Mounted in alignment with the groove 21 and well 21' is a laser chip 23. The depth of the groove is such that the core of the fibre 19 is aligned with the output of the laser chip 23. The laser chip 23 has its electrical contacts on its face adjacent the substrate, as have the driver/multiplexer chips 24 and 25, which may be of silicon or gallium arsenide. These chips are electrically and thermally contacted to the substrate 20 using bumps of solder on photolithographically defined pads. This is by the so-called self-aligned solder bump technology in which surface tension pulls the chips into alignment to an accuracy of the order of 0.5µm. The photolithographically defined pads form part of the electrical connections referred to above which may involve one of the so-called HDI (high density electrical interconnect) technologies, for example interconnects using multiple level of polyimide and a metal. A monitor photodiode chip 26 is mounted to monitor the output from the back face of the laser chip 23. This chip 26 too has its electrical contacts on its face adjacent the substrate and also its active area which performs detection. The side walls and end inclined wall of the well 21' serve to reflect light output from the back face of the laser chip to the active area. The receiver module is similar to the transmitter module. In that case the laser chip is omitted and the V-groove extends part way under the photodetector chip, corresponding to the monitor photodiode. The chips 24 and 25 would in this case comprise demultiplexer and other functions required at the receiver module. WO 90/077792 (Motorola) provides a method of making high density solder bumps and a substrate socket for high density solder bumps. JP 62280056 (Hitachi) provides a method of connecting an IC chip to a substrate by flip-chip bonding techniques. JP57172308 (Tateishi Denki) describes a method of coupling a laser to an optical waveguide.

One of the aims of the present invention is to provide a practical process for producing the modules referred to above.

According to one aspect of the present invention there is provided a process for providing solder bumps on a solder-wettable pad provided on a non-wettable substrate in a flip-chip bonding technique, the process being characterised by the steps of providing defining a solder element on the pad and within the pad's circumferential edge, heating the arrangement whereby to melt the solder for reflow thereof, the molten solder being such as to flow to the edge of the wettable pad and cover the entirety thereof, and cooling the arrangement thereby forming a said bump.

According to another aspect of the present invention there is provided a process for manufacturing opto-electronic hybrid modules, said process comprising the steps of: forming V-grooves in one surface portion of a silicon substrate; depositing an electrically conducting ground plane over the substrate including the grooves; depositing a first dielectric layer on the ground plane; forming vias in the first dielectric layer; defining an electrical interconnect pattern on the first dielectric layer which is in contact with the ground plane by way of the vias; depositing a second dielectric layer on the first dielectric layer and interconnect pattern; forming vias in the second dielectric layer whereby to expose the interconnects and the ground plane; depositing solder-wettable material in the vias in the second dielectric layer whereby at least to provide solder-wettable pads at positions where solder bumps for use in flip-chip bonding of opto-electronic components are to be formed; defining solder elements on said pads; reflowing the solder elements in a wetforward fashion to form solder bumps thereat; disposing said opto-electronic components having corresponding solder-wettable pads on said solder bumps; heating the arrangement to melt the solder, whereby surface tension forces cause alignment of the opto-electronic components with respect to the processed substrate.

Embodiments of the invention will now be described with reference to the accompanying drawings, in which
Fig. 1 illustrates a 32 Gbit/s optical bus based on passive star couplers;
Fig. 2 illustrates a basic array transmitter module;
Fig. 3 illustrates a basic single fibre transmitter module;
Fig. 4 illustrates in cross-section a transmitter module manufactured by a process according to the present invention;
Fig. 5 illustrates schematically a plan view of a transmitter module manufactured by a process according to the present invention;
Fig. 6a and 6b show in plan view and section, respectively a backface photodetector array which is mounted at the position indicated by the dotted box in Fig 5; and
Figs. 7a and 7b illustrate the wet-back and wet-forward processes respectively.

The transmitter module illustrated in Figs. 4 to 6 is a silicon opto-hybrid module. Silicon possesses a unique combination of properties as a substrate material for opto-hybrid modules. It has excellent mechanical stability and thermal conductivity. Its thermal expansion coefficient matches that of silicon integrated circuits mounted on it and corresponds more closely to that of GaAs and InP than the ceramic, copper or diamond headers conventionally used. This results in a reduction in the stress induced during bonding and is particularly important for laser arrays which can fail to operate if the laser stripe is subject to significant stress.

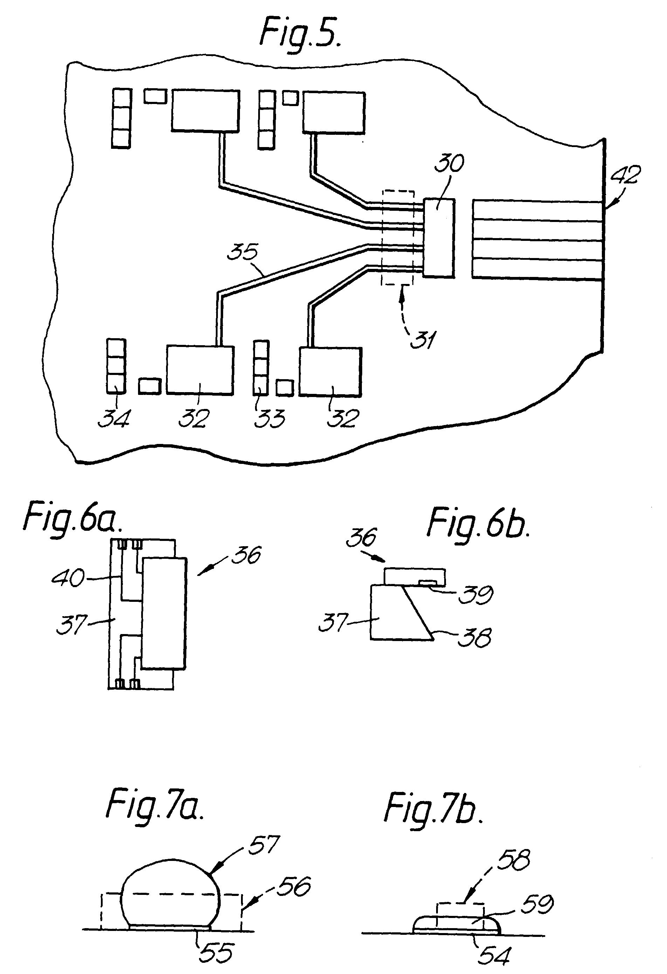

The illustrated module of Figs. 4 to 6 has only four optical fibres, lasers, drivers etc. for the sake of simplicity, but the processing to be described hereinafter is not to be considered as so limited. Furthermore single laser drivers are shown in Figs. 5 and 6 whereas the lasers and backface detectors are provided in the form of arrays 30 and 36. The laser driver integrated circuits 32 have associated passive components such as capacitor 33 and resister 34. Only some of the interconnection tracks, namely those 35 to the laser drivers, are indicated in Fig. 5. The backface detectors comprise a PIN photodetector array 36 mounted on an etched silicon submount 37, the angled surface 38 reflecting light to the active areas such as 39 of the array. The submount has respective conductive tracks 40 whereby the detectors can be connected to the respective laser drivers. The submount is mounted in place at the position indicated by the dotted box 31 in Fig. 5 so that light from the backface of the laser array is incident thereon.

The processing steps to achieve the module construction whose cross-section is illustrated in Fig 4 will now be described. The starting material is a standard silicon substrate 41. V-grooves 42, which are to locate the fibres, are provided at the required location on the substrate 41 by the well-established anisotropic etching technique. For example, a 0.1µm (1000Å) layer of Si₃N₄ is deposited on the surface of the substrate 41. The nitride layer is then patterned by using reactive ion etching (RIE) in Freon 14/8 % oxygen using a photoresist layer as a mask. As a result the nitride is removed in selected areas where the V-grooves are to be provided. The photoresist is removed and the V-grooves etched in the silicon using a suitable etchant such as KOH diluted in IPA and water, etching being carried out at 80°C. A suitable solution comprises 6 litres of deionised water, 2 litres of IPA and 1.5kg of KOH. This attacks the (100) surfaces preferentially producing the V-grooves 42 with side walls in the (111 ) plane. The widths and depths of the V-grooves 42 formed in this way can be controlled to less than a micron. Since the etch mask is defined photolithographically, the grooves can be positioned to submicron accuracies with respect to other features, for example the bond pads of optoelectronic components to be described hereinafter.

Following etching of the V-grooves 42, the remaining nitride film is removed such as by using the same reactive ion etcher referred to above for patterning it. A Cr/Au ground plane 43 is then deposited on the substrate surface containing the grooves by evaporation of 0.03µm (300Å) Cr and 0.5µm Au. This is then patterned photolithographically and wet etched using KI/I in order to remove it from areas where a ground plane is not required, such as under the laser array. The Cr/Au is left in the V-grooves 42 as a protection layer for reasons which will be apparent in the following description. Following removal of the ground plane resist, a 2 micron layer of silicon dioxide dielectric 44 is deposited such as by PE CVD. This is then patterned photolithographically and etched to give via holes 45 down to the ground plane 43 where required. Vias with sloping sidewalls can be achieved by RIE using an erodable resist mask together with gases such as Freon 23 and oxygen. That resist is then removed and the wafer patterned for interconnects using a resist/lift off pattern. The interconnects 46 and 49 are of deposited layers on one another of Cr, Cu and Au, being 0.03µm (300 Å), 0.5µm and 0.2µm (2000Å) thick respectively, for example. The interconnects 46 extend between the integrated circuits (drivers) such as 47 and a respective laser of the array 30, see also Fig. 5, and also form contact layers 49 through the via holes 45 down to the ground plane 43. The associated resist is then removed and a second layer 50 of silicon dioxide deposited on the wafer surface and patterned in a similar manner to the first but using an appropriate mask, in order to open up via holes 51 through to the Cr/Au ground plane 43 and through to the Cr/Cu/Au interconnects.

Using appropriate lift-off photolithographic patterning successive layers of Ti, Pt and Au are deposited to form wettable pads 52 for the laser array in the via holes corresponding thereto and in any other vias in order to make interconnects for any passive components such as 53 and the integrated circuit such as 47. The resist is then removed and a Au/Sn solder deposited over the whole surface. An 80% Au 20% Sn composition is currently preferred (melting point 280°C) and this can be applied using a multilayer deposition process, alternate layers of Au and Sn, to give the required 80/20 composition. This AuSn solder layer is patterned photolithographically and wet etched using 2: 1 HNO₃: HCI. The AuSn solder is only required in the vicinity of the wettable pads i.e. at 54 and is to be employed in bonding the laser array in place by a solder bump technology.

Conventional solder bump technology involves a wet back technique, see Fig. 7a, with a wettable pad 55 on a non-wettable substrate. A solder layer element 56 (dotted lines) is defined which extends beyond the edges of the wettable pad 55. This element is reflowed to make a solder bump 57 which only extends over the wettable area i.e. wettable pad 55. This is known as a wetback process since the solder flows "back" to the edges of the pad during reflow because the substrate is non-wettable.

We, however, propose the use of a wetforward technique for providing solder bumps for use in flip-chip bonding. The AuSn solder layer is patterned so that the solder layer element 58 Fig. 7b as defined photolithographically is smaller than the wettable pad 54 on which it is disposed. When this element 58 is reflowed to make a bump 59 it spread out over the entire wettable pad i.e. it flows forward (wetforward). The use of 2 HNO₃/HCI to etch the AuSn results in an oxide border around the solder element. This oxide must be removed as it will restrict the reflow of the solder and hence the self-aligning process. This oxide removal can be achieved by etching the wafer for 20 minutes with an etchant comprised of 60g KOH in 100ml water. The silicon V-grooves are protected from this etchant by the Cr/Au, which was specifically not removed therefrom during the ground plane definition process. This etchant cleans up the exposed surface of the solder elements so that a fluxless reflow of the solder elements to produce the required solder bumps can be employed. Such reflow is carried out in an inert atmosphere for example of hydrogen or nitrogen. The thickness of the deposited AuSn must clearly be sufficient to achieve wetforward and a sufficient bond in the completed module.

A laser array 30 is subsequently bonded to the solder bumps. The array is provided with corresponding metallisation i.e. wettable pads of Ti/Pt/Au and when the array is positioned with the metallisation aligned with the solder bumps and the assembly raised to the melting point of the AuSn solder the solder wets the wettable pads of the laser array and surface tension forces pull the two components into a very accurate final alignment. The passive components are bonded in position using either solder or a conductive epoxy whereas the drive integrated circuit is mounted using epoxy. Wire bond interconnections such as those indicated at 60 can be made to complete the necessary interconnections. The PIN photodetectors array 36 is mounted to the silicon submount 37 using the same wetforward technique with AuSn solder and Ti/Pt/Au wettable pads. The silicon submount 37 is mounted in the required position at 31 relative to the back face of the laser array.

The laser arrays are manufactured by a process which is such that the individual laser isolation and the wettable pads are formed by a single self-aligned photolithographic stage. An Au/Pt/Ti layer is provided. The photoresist mask is defined and then the Au/Pt layer on the array is removed using Xenon ion beam milling. In the last stages of this etch SF₆ is added to remove the underlying Ti. Using this as a mask the underlying oxide is removed by RIE in Freon 23 and oxygen and finally the quaternary layer is removed by wet etching in 3 phosphoric acid: 1 HCI. Any resist is then removed.

The use of a wet forward process as described above is advantageous since there is no possibility of droplets and debris being left outside of the wettable pad area as in the case of the wetback process, which droplets/debris could cause erroneous operation or failure of the module. With the wet-forward process the solder moves as a wave to the edge of the wettable pad, engulfing anything in its path, although there should not be any such material there if the processing is carried out correctly. Wetforward processing results in a very well defined solder bump with sharp edge around the wettable pad, as the solder runs right out to the edge. With a pulling back process the effect may not be symmetrical all round the pad. The wetback process means that "thin" solder layers are put down whilst a thick solder bumps results after reflow. With a wetforward process the resultant solder bump will actually be less high than the deposited solder layer. In the present case the deposited layer is required only to be approximately 5µm for wetforward and such thicknesses can readily be achieved. Conventional wetback techniques with SnPb solder generally form 10-20µm high bumps.

## Claims

1. A process for providing solder bumps (59) on a solder wettable pad (54) provided on a non-wettable substrate in a flip-chip bonding technique, the process being characterised by the steps of defining a solder element (58) on the pad and within the pad's circumferential edge, heating the arrangement whereby to melt the solder for reflow thereof, the molten solder being such as to flow to the edge of the wettable pad and cover the entirety thereof, and cooling the arrangement thereby forming a solder bump.

2. A process as claimed in claim 1 wherein the solder is 80% Au/ 20% Sn.

3. A process as claimed in claim 1 or 2 wherein the solder-wettable pad comprises Ti, Pt and Au.

4. A process as claimed in claim 3 wherein the solder-wettable pad comprises successively deposited layers of Ti, Pt and Au.

5. A process as claimed in claim 3 when dependent upon claim 2 wherein the AuSn solder element is defined photolithographically on the pad and the etchant used to remove the unwanted AuSn results in an oxide layer around the circumferential border of the element and including the step of removing the oxide layer, which oxide removal step permits a fluxless reflow of the solder element to be carried out.

6. A process as claimed in claim 5, wherein the reflow is carried out in an inert atmosphere.

7. A process as claimed in claim 5 wherein the AuSn is etched with a mixture of HNO₃ and HCI.

8. A process for manufacturing opto-electronic hybrid modules and including the provision of solder bumps by a process according to any one of the previous claims.

9. A process for manufacturing opto-electronic hybrid modules, said process comprising the steps of:
forming V-grooves (42) in one surface portion of a silicon substrate (41);
depositing an electrically conducting ground plane (43) over the substrate including the grooves;
depositing a first dielectric layer (44) on the ground plane;
forming vias (45) in the first dielectric layer;
defining an electrical interconnect pattern (46, 49) on the first dielectric layer which is in contact with the ground plane by way of the vias;
depositing a second dielectric layer (50) on the first dielectric layer and interconnect pattern;
forming vias (51) in the second dielectric layer whereby to expose the interconnects and the ground plane;
depositing solder-wettable material in the vias in the second dielectric layer whereby at least to provide solder-wettable pads (52) at positions where solder bumps for use in flip-chip bonding of opto-electronic components are to be formed;
defining solder elements on said pads;
reflowing the solder elements in a wetforward fashion to form solder bumps thereat;
disposing said opto-electronic components (30) having corresponding solder-wettable pads on said solder bumps;
heating the arrangement to melt the solder, whereby surface tension forces cause alignment of the opto-electronic components with respect to the processed substrate.

10. A process as claimed in claim 9 further including the steps of mounting lasers, laser driver integrated circuits, backface photodetector arrays and passive components to the processed substrate.

11. A process as claimed in claim 9 or 10 wherein at least one electro-optic module comprises a laser array, which laser array is manufactured in a step such that individual laser isolation and the wettable pads are formed in a single self-aligned photolithographic stage.

12. A process as claimed in any one of claims 9 to 11 wherein the ground plane is of Cr/Au, and wherein the solder-wettable material is of Ti, Pt and Au.

## Patentansprüche

1. Verfahren zur Schaffung von Lötbuckeln (59) auf einem mit Lot benetzbaren Anschlußfleck 54, der auf einem nichtbenetzbaren Substrat ausgebildet ist, in einer Flip-Chip-Kontaktierungstechnik, wobei das Verfahren durch die folgenden Schritte gekennzeichnet ist: Ausbildung eines Lotelementes (58) auf dem Anschlußfleck innerhalb der Umfangskante des Anschlußflecks, Erhitzen der Anordnung, wodurch das Lot zu dessen Aufschmelzen geschmolzen wird und das geschmolzene Lot derart ist, daß es bis zur Kante des benetzbaren Anschlußflecks fließt und dieses vollständig bedeckt, und Abkühlen der Anordnung, wordurch ein Lötbuckel gebildet wird.

2. Verfahren nach Anspruch 1, bei dem das Lot 80% Au/20% Sn ist.

3. Verfahren nach Anspruch 1 oder 2, bei dem der mit Lot benetzbare Anschlußfleck Ti, Pt und Au umfaßt.

4. Verfahren nach Anspruch 3, bei dem der mit Lot benetzbare Anschlußfleck aufeinanderfolgend abgeschiedene Schichten aus Ti, Pt und Au umfaßt.

5. Verfahren nach Anspruch 3 unter Rückbeziehung auf Anspruch 2, bei dem das AuSn-Lotelement photolithographisch auf dem Anschlußfleck ausgebildet wird und das zur Entfernung des unerwünschten AuSn verwendete Ätzmittel zu einer Oxydschicht um den Umfangsrand des Elementes führt, wobei das Verfahren den Schritt der Entfernung der Oxydschicht einschließt und dieser Schritt der Entfernung des Oxyds die Ausführung eines flußmittelfreien Aufschmelzens des Lotelementes ermöglicht.

6. Verfahren nach Anspruch 5, bei dem das Aufschmelzen in einer inerten Atmosphäre ausgeführt wird.

7. Verfahren nach Anspruch 5, bei dem das AuSn mit einer Mischung von HNO₃ und HCl geätzt wird.

8. Verfahren zur Herstellung von optoelektonischen Hybrid-Moduleinheiten, das die Schaffung von Lötbuckeln mit Hilfe eines Verfahrens nach einem der vorhergehenden Ansprüche einschließt.

9. Verfahren zur Herstellung von optoelektronischen Hybrid-Moduleinheiten, wobei das Verfahren die folgenden Schritte umfaßt:
Ausbilden von V-förmigen Nuten (42) in einem Oberflächenteil eines Siliziumsubstrats (41),
Abscheiden einer elektrisch leitenden Erdebene (43) über dem Substrat unter Einschluß der Nuten,
Abscheiden einer ersten Isolierschicht (44) auf der Erdebene,
Ausbildung von Durchgangsöffnungen (45) in der ersten Isolierschicht,
Ausbilden eines elektrischen Zwischenverbindungsmusters (46, 49) auf der ersten Isolierschicht, das mit der Erdebene über die Durchgangsöffnungen in Kontakt steht,
Abscheiden einer zweiten Isolierschicht (50) auf der ersten Isolierschicht und dem Zwischenverbindungsmuster,
Ausbildung von Durchgangsöffnungen (51) in der zweiten Isolierschicht, wodurch die Zwischenverbindungen und die Erdebene freigelegt werden,
Abscheiden von mit Lot benetzbarem Material in den Durchgangsöffnungen in der zweiten Isolierschicht, wodurch mit Lot benetzbare Anschlußflecken zumindest an Positionen geschaffen werden, an denen Lötbuckel zur Verwendung bei der Flip-chip-Kontaktierung von optoelektronischen Bauteilen auszubilden sind,
Ausbildung von Lotelementen auf den Anschlußflecken,
Aufschmelzen der Lotelemente in einer Vorwärtsbenetzungsweise zur Bildung von Lötbuckeln an diesen Stellen,
Anordnen der optoelektronischen Bauteile (30) mit entsprechenden mit Lot benetzbaren Anschlußflecken auf den Lötbuckeln,
Erhitzen der Anordnung zum Schmelzen des Lots, wodurch Oberflächenspannungskräfte eine Ausrichtung der optoelektronischen Bauteile bezüglich des verarbeiteten Substrats hervorrufen.

10. Verfahren nach Anspruch 9, das weiterhin die Schritte der Befestigung von Lasern, integrierten Laser-Treiber-Schaltungen, Rückflächen-Photodetektorgruppen und passiven Bauteilen auf dem verarbeiteten Substrat einschließt.

11. Verfahren nach Anspruch 9 oder 10, bei dem zumindest eine der elektrooptischen Moduleinheiten eine Lasergruppe umfaßt, die in einem derartigen Schritt hergestellt ist, daß die einzelne Laserisolation und die benetzbaren Anschlußflecken in einer einzigen selbstausgerichteten photolithographischen Stufe ausgebildet werden.

12. Verfahren nach einem der Ansprüche 9 bis 11, bei dem die Erdebene aus Cr/Au besteht, und bei dem das mit Lot benetzbare Material aus Ti, Pt und Au besteht.

## Revendications

1. Procédé de disposition de saillies (59) de soudure sur une plage (54) mouillable par la soudure placée sur un substrat non mouillable pour une technique de liaison de dispositifs planaires, le procédé étant caractérisé par les étapes suivantes : la délimitation d'un élément de soudure (58) sur la plage et à l'intérieur du bord circonférentiel de la plage, le chauffage de l'ensemble afin que la soudure fonde et subisse une refusion, la soudure fondue étant telle qu'elle s'écoule vers le bord de la plage mouillable et recouvre la totalité de celle-ci, et le refroidissement de l'ensemble avec formation de cette manière d'une saillie de soudure.

2. Procédé selon la revendication 1, dans lequel la soudure est du type Au 80 %-Sn 20 %.

3. Procédé selon la revendication 1 ou 2, dans lequel la plage mouillable par la soudure cotient Ti, Pt et Au.

4. Procédé selon la revendication 3, dans lequel la plage mouillable par la soudure comporte des couches déposées successivement de Ti, Pt et Au.

5. Procédé selon la revendication 3, lorsqu'elle dépend de la revendication 2, dans lequel l'élément de soudure de AuSn est délimité par photolithographie sur la plage, et la matière d'attaque utilisée pour l'extraction de AuSn indésirable donne une couche d'oxyde autour de la bordure circonférentielle de l'élément, le procédé comprenant l'étape d'extraction de la couche d'oxyde, cette étape d'extraction de la couche d'oxyde permettant l'exécution d'une refusion sans flux de l'élément de soudure.

6. Procédé selon la revendication 5, dans lequel la refusion est réalisée en atmosphère inerte.

7. Procédé selon la revendication 5, dans lequel l'élément de AuSn est attaqué par un mélange de HNO₃ et HCl.

8. Procédé de fabrication de modules hybrides opto-électroniques, comprenant la disposition de saillies de soudure par mise en oeuvre d'un procédé selon l'une quelconque des revendications précédentes.

9. Procédé de fabrication de modules hybrides opto-électroniques, comprenant les étapes suivantes :
la formation de gorges en V (42) dans une partie de la surface d'un substrat de silicium (41),
le dépôt d'un plan de masse (43) conducteur de l'électricité sur le substrat, y compris les gorges,
le dépôt d'une première couche diélectrique (44) sur le plan de masse,
la formation d'interconnexions (45) entre couches dans la première couche diélectrique,
la délimitation d'un motif électrique d'interconnexions (46, 49) sur la première couche diélectrique qui est au contact du plan de masse par l'intermédiaire des interconnexions,
le dépôt d'une seconde couche diélectrique (50) sur la première couche diélectrique et le motif d'interconnexions,
la formation d'interconnexions (51) entre couches dans la seconde couche diélectrique afin que les interconnexions et le plan de masse soient exposés,
le dépôt d'un matériau mouillable par de la soudure dans les interconnexions de la seconde couche diélectrique afin que des plages (52) mouillables par de la soudure soient formées au moins à des emplacements auxquels doivent être formées des saillies de soudure destinées à être utilisées pour la liaison de dispositifs planaires de composants opto-électroniques,
la délimitation d'éléments de soudure sur les plages,
la refusion des éléments de soudure avec avance de liquide pour la formation des saillies de soudure,
la disposition de composants opto-électroniques (30) ayant des plages correspondantes mouillables par la soudure sur les saillies de soudure, et
le chauffage de l'ensemble afin que la soudure fonde, si bien que les forces de tension superficielle provoquent un alignement des composants opto-électroniques par rapport au substrat traité.

10. Procédé selon la revendication 9, comprenant en outre des étapes de montage de lasers, de circuits intégrés de pilotage de laser, de matrices de photodétecteurs de face arrière et de composants passifs sur le substrat traité.

11. Procédé selon la revendication 9 ou 10, dans lequel un module opto-électronique au moins comprend une matrice de lasers, cette matrice de lasers étant fabriquée dans une étape telle qu'un isolement de laser individuel et les plages mouillables sont formés en une seule étape photolithographique avec alignement automatique.

12. Procédé selon l'une quelconque des revendications 9 à 11, dans lequel le plan de masse est formé de Cr/Au, et le matériau mouillable par la soudure est formé de Ti, Pt et Au.
